# EUROPEAN PATENT SPECIFICATION

(11) **EP 0 499 479 B1**
(45) Date of publication and mention of the grant of the patent: **27.08.1997**
(21) Application number: 92301224.9
(22) Date of filing: 14.02.1992
(51) Int. Cl.: H04L 7/033, H03L 7/085

(54) **Clock regeneration circuit**
Schaltungsanordnung zur Taktrückgewinnung
Circuit de regénération d'horloge

(30) Priority: 15.02.1991 JP 22032/91
(43) Date of publication of application: 19.08.1992
(73) Proprietor: NEC CORPORATION, Tokyo (JP)
(72) Inventor: Yoshida, Yasuharu, c/o NEC Corporation, Minato-ku, Tokyo (JP); Kuroda, Yuka, c/o NEC Engineering Ltd., Minato-ku, Tokyo (JP); Fukuda, Seiji, c/o NEC Engineering Ltd., Minato-ku, Tokyo (JP)
(74) Representative: Orchard, Oliver John

(56) References cited:
- EP-A- 0 209 306
- US-A- 4 129 748
- PATENT ABSTRACTS OF JAPAN vol. 10, no. 32 (E-379)(2099) 7 February 1986 & JP-A-60 190 023

## Description

The present invention relates to a clock regeneration circuit and, more particularly, to a clock regeneration circuit for regenerating an improved clock signal from a CMI (Coded Mark Inversion) coded binary signal.

A circuit for regenerating a clock signal from a CMI coded binary signal, or simply CMI signal as referred to hereinafter, is disclosed in U.S. Patent 4, 823, 363. The circuit has a D-type flip-flop which receives a CMI signal at a data input terminal and a regenerated clock signal at a clock input terminal, a low pass filter for smoothing the output of the flip-flop, and a voltage controlled oscillator (VCO) for producing a regenerated clock signal with the oscillation frequency thereof controlled in matching relation to the output of the low pass filter. Such a conventional clock regeneration circuit does not need a tank circuit and is, therefore, easy to implement an integrated circuit. In addition, this kind of circuit suffers from a minimum of phase jitter.

However, the problem with the above-described clock regeneration circuit is that it fails to accurately regenerate a clock signal when a "1" signal continuously appears in the original information signal before it has undergone CMI coding, since it is difficult to lock the phase of the VCO to that of the CMI signal for reasons which will be described later.

It is, therefore, a feature of an embodiment of the present invention to provide a clock regeneration circuit capable of regenerating a clock signal stably with less dependence on the content of an original information signal.

In accordance with features of this embodiment, a clock regeneration circuit for extracting a regenerated clock signal from a binary CMI signal has oscillating means for generating the regenerating clock signal by having the frequency thereof changed by a control signal, sampling means for sampling the regenerated clock signal by using the CMI signal as a timing signal to thereby produce a sampled signal, and control signal generating means for smoothing the sampled signal to thereby generate the control signal.

A D-type flip-flop having a regenerated clock signal fed back to its D input has been disclosed for synchronizing a television signal in US Patent 4 129 748 but the above problem of CMI signals does not arise in video synchronizing bursts.

The above and other objects, features and advantages of the present invention will become more apparent from the following detailed description taken with the accompanying drawings in which:
FIG. 1 is a block diagram schematically showing a conventional clock regeneration circuit;
FIG. 2 is a timing chart useful for understanding the operation of the circuit shown in FIG. 1;
FIG. 3 is a block diagram schematically showing a clock regeneration circuit embodying the present invention; and
FIG. 4 is a timing chart demonstrating a specific operation of the embodiment.

### DETAILED DESCRIPTION OF THE INVENTION

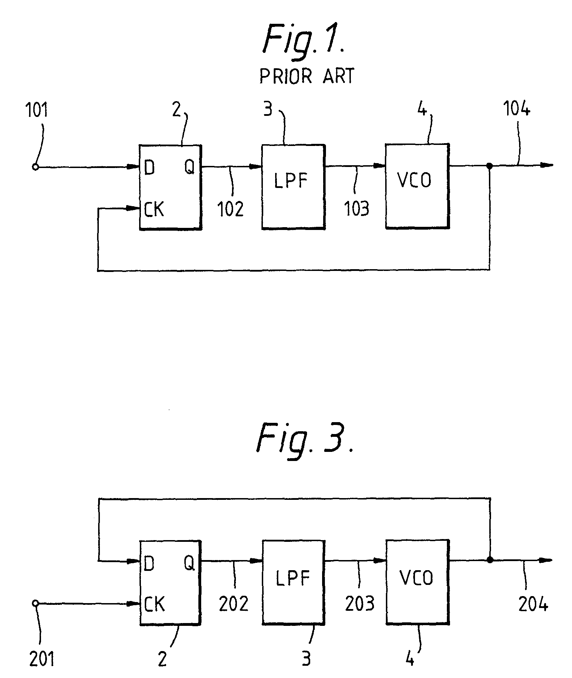

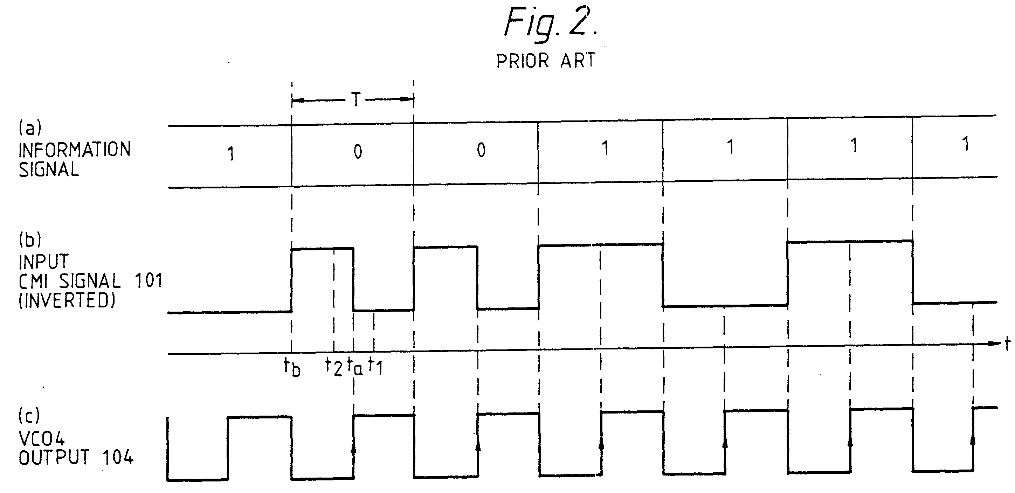

To better understand the present invention, a brief reference will be made to a prior art clock regeneration circuit of the type disclosed in U.S. Patent 4,823,363, shown in FIG. 1. A CMI signal is a binary NRZ (Non-Return to Zero) signal formatted such that an original signal "0" of symbol rate 1/T and corresponding to "0,1" having a twice greater bit rate and an original signal "1" corresponding to either "0, 0" or "1,1" are sent alternately with each other, as well known in the art. FIG. 2 (b) shows an inverted signal of such a CMI signal. In the following description relating to FIGS. 1 and 2 (a)-2 (c), let the inverted CMI signal be referred to as an input CMI signal. In FIG. 1, the input CMI signal 101 is applied to an input terminal D of a D-type flip-flop (FF) 2 while the oscillation output of a VCO 4 is applied to a timing terminal C of the FF 2.

Assume that the original information signal is "0", as shown in FIG. 2(a). Then, the input CMI signal has a negative-going edge at the intermediate point ta of a time slot T and has no positive-going edges there. The output of the FF 2 is "0" when the phase in which the output 104 of the VCO 4 goes high is more advanced than the intermediate point ta of the time slot T (sampling point being t1) or is "1" when the former is more retarded than the latter (sampling point being t2). In this manner, the FF2 produces an output 102 representative of a phase error between the input CMI signal 101 and the output 104 of the VCO 4. A low pass filter (LPF) 3 removes noise and needless high frequency components from the FF output 102, producing a low frequency signal component 103. The low frequency signal component 103 retards the output 104 of the VCO 4 if the ratio of "0" in the FF output 102 is great or advances it if the ratio of "1" is great, thereby causing "0" and "1" to appear in the same ratio in the FF output 102. On the other hand, when the original data signal is "1", neither a positive-going edge nor a negative-going edge occurs at the intermediate point ta of the time slot T. Hence, "1" and "0" appear in the same probability as each other in the output 102 of the FF 2 and, therefore, do not effect the control over the VCO oscillation frequency at all.

At the boundary point tb between nearby time slots T, positive- and negative-going edges occur. Therefore, the output 102 of the FF 2 does not have regularity with respect to phase error, i.e., no phase error signal is obtainable. In such a condition, the phase of the output 102 of the VCO 4 is prevented from being locked to the phase tb of the input CMI signal 101.

As stated above, the prior art clock regeneration circuit controls the output 104 of the VCO 4 on the basis of "0" of the original information signal such that the sampling point of the FF 2 coincides with the intermediate point ta of the time slot T. As a result, the output 104 of the VCO 4 is locked to the phase of the input CMI signal 101.

However, assume that the original information signal is all "1", i.e. , AIS (Alarm Indication Signal) as prescribed by CCITT. Then, since neither a positive-going edge nor a negative-going edge occurs at the intermediate point ta of the time slot T, the output of the FF 2 has "1" and "0" in the same ratio with no regard to the phase error, i.e., whether the positive-going edge of the output 104 of the VCO 4 is advanced in phase (sampling point being t1) or retarded in phase (sampling point being t2). More specifically, since the output of the FF 2 does not include any information relating to the phase error relative to the input CMI signal, the phase of the output of the VCO 4 cannot be locked to the phase of the input CMI signal. The conventional timing extracting circuit, therefore, fails to extract a timing, depending on the content of the original information signal.

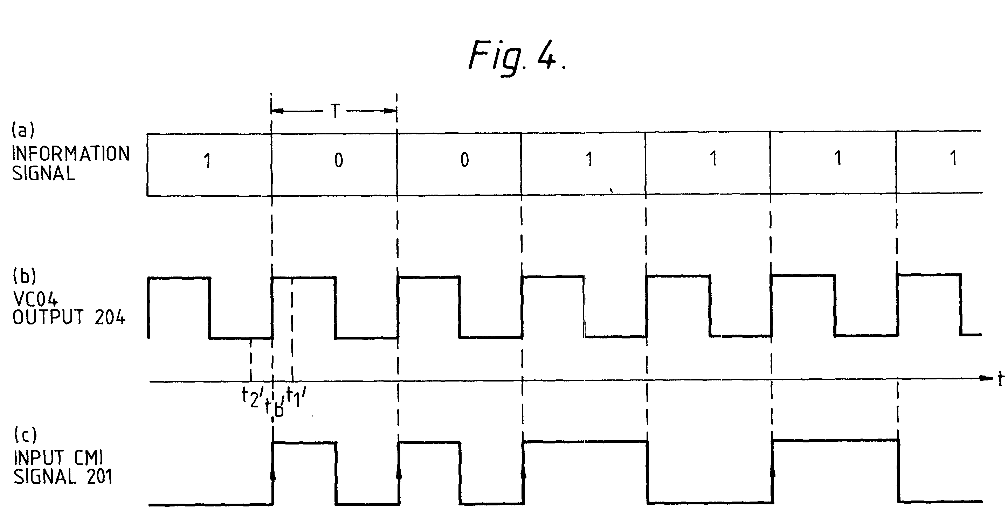

Referring to FIG. 3, a clock regeneration circuit embodying the present invention is shown. As shown, the clock regeneration circuit has a D-type FF 2 which receives an input CMI signal (non-inverted) 201 at a timing terminal C and receives the output of a VCO 4 at an input terminal D.

As shown in FIG. 4, when the original signal is "0", the input CMI signal 201 goes high, i. e., a positive-going edge occurs only at the boundary point tb of a time slot T without exception. When the positive-going edge of the output 204 of the VCO 4 occurs in a phase more advanced than the boundary point tb of the time slot T (sampling point being t2'), the output of the FF 2 is "0"; when the former occurs in a phase more retarded than the latter (sampling point being t1'), the output of the FF 2 is "1". As a result, the FF 2 produces an output 202 representative of a phase error between the CMI signal 201 and the output 204 of the VCO 4. An LPF 3 removes noise and needless high frequency components from the FF output 202, producing a low frequency component 203. The low frequency component 203 retards the output 204 of the VCO 4 if the ratio of "0" in the FF output 202 is great or advances it if the ratio of "1" is great, so that "0" and "1" may appear in the same ratio as each other. That is, the VCO output 204 is so controlled as to cause the sampling point to coincide with the boundary point tb of the time slot T, thereby locking the phase of the VCO output 204 to the phase of the input CMI signal 201.

When the original information signal is "1", a positive-going edge occurs in the input CMI signal 201 every two time slots. When the output 204 of the VCO 4 is more advanced than the boundary point tb of the time slot where a positive-going edge exists, the output of the FF 2 is "0"; when the former is more retarded than the latter, the FF output is "1". Then, the low frequency component 103 controls the VCO output 204 such that "1" and "0" have the same ratio as each other in the FF output 202, i.e., the sampling point coincides with the boundary point tb of the time slot T. As a result, the phase of the VCO output 204 is locked to the phase of the input CMI signal 201. Therefore, even when the original information signal is a string of "1", i. e., AIS, timing information can be stably extracted at all times since the FF output 202 contains information representative of a phase error between the input CMI signal 201 and the VCO output 204.

Further, even with AIS or similar original information signal which is not all "1", the present invention is capable of regenerating a clock more accurately than the conventional clock regenerating circuit shown in FIG. 1, for the following reason. Assume an ordinary original information signal wherein "0" and "1" each occurs in the probability of 1/2 by way of example.

The conventional clock generating circuit shown in FIG. 1 can detect information representative of a phase error between the VCO output 104 and the input CMI signal only in the time slots in which the original information signal is "0", as stated previously. With such a circuit, therefore, it is possible to detect phase error information in substantially one half of time time slots.

By contrast, the present invention is capable of detecting phase error information between the VCO output 204 and the input CMI signal not only in the time slots wherein the original information signal is "0" but also in the time slots wherein it is "1" in the probability of 1/2. It follows that the present invention can detect such information in three-fourths of all the time slots.

It will be seen from the above that the present invention can regenerate a clock more accurately than the conventional clock regeneration circuit.

In summary, the present invention provides a clock regeneration circuit capable of extracting timing information stably with no regard to the content of the original information signal of a CMI signal, e. g., even with AIS which is a string of "1". This is because the circuit of the present invention obtains phase error information by sampling the output of a VCO, which can oscillate at a clock frequency, at the boundaries of the time slots of the CMI signal.

Various modifications will become possible for those skilled in the art after receiving the teachings of the present disclosure without departing from the scope of the claims thereof.

## Claims

1. A clock regeneration circuit for extracting a regenerated clock signal (204) from a CMI coded binary signal (201) fed to a D-type flip-flop (2), comprising:
oscillating means (4) for generating said regenerated clock signal (204) by having the frequency thereof changed by a control signal (203);
low pass filtering means (3) for low pass filtering a sampled signal (202) to generate and transmit said control signal (203) to said oscillating means (4) for changing the frequency of said regenerated clock signal (204) to synchronize the cycle period of said regenerated clock signal (204) with each of said plurality of time slots of said CMI coded binary signal (201); and
means to feed the regenerated clock signal (204) also to the D-type flip-flop (2) characterized in that said clock regeneration circuit further comprises
sampling means (2) for sampling said regenerated clock signal (204) at a boundary point of each of said plurality of time slots of said CMI coded binary signal (201) to thereby produce a sampled signal by using the D-type flip-flop (2) having a timing signal input terminal (CK) arranged to receive an inverted signal of said CMI coded binary signal (201), and a data input terminal (D) arranged to receive said regenerated clock signal (204).

## Revendications

1. Circuit de régénération d'horloge destiné à extraire un signal d'horloge régénéré (204) à partir d'un signal binaire codé CMI (201) envoyé vers une bascule du type D (2), comportant :
des moyens d'oscillation (4) destinés à engendrer ledit signal d'horloge régénéré (204) en modifiant la fréquence de ce signal par l'intermédiaire d'un signal de commande (203),
des moyens de filtrage passe-bas (3) destinés à filtrer par filtrage passe-bas un signal échantillonné (202) afin d'engendrer et de transmettre ledit signal de commande (203) vers lesdits moyens d'oscillation (4) pour modifier la fréquence dudit signal d'horloge régénéré (204) dans le but de synchroniser la période du cycle dudit signal d'horloge régénéré (204) avec chacun de ladite pluralité d'intervalles de temps dudit signal binaire codé CMI (201), et
des moyens pour envoyer aussi le signal d'horloge régénéré (204) vers la bascule du type D (2), caractérisé en ce que ledit circuit de régénération d'horloge comporte en outre
des moyens d'échantillonnage (2) pour échantillonner ledit signal d'horloge régénéré (204) au niveau d'un point limite de chacun de ladite pluralité d'intervalles de temps dudit signal binaire codé CMI (201) afin de produire un signal échantillonné en utilisant la bascule du type D (2) ayant une borne d'entrée de signal de cadencement (CK) prévue pour recevoir un signal inversé dudit signal binaire codé CMI (201), et une borne d'entrée de données (D) prévue pour recevoir ledit signal d'horloge régénéré (204).

## Patentansprüche

1. Taktrückgewinnungsschaltung zum Extrahieren eines rückgewonnenen Taktsignals (204) aus einem CMI-kodierten Binärsignal (201), das einem D-Flipflop (2) zugeführt wird, die aufweist:
Oszillatoreinrichtung (4) zum Erzeugen des rückgewonnenen Taktsignals (204), indem dessen Frequenz von einen Steuersignal (203) geändert wird;
Tiefpaßfiltereinrichtung (3) zum Tiefpaßfiltern eines abgetasteten Signals (202), um das Steuersignal (203) zu erzeugen und an die Schwingungseinrichtung (4) zu übertragen, um die Frequenz des rückgewonnenen Taktsignals (204) zu ändern, um die Schwingungsperiode des rückgewonnenen Taktsignals (204) mit jedem einer Mehrzahl von Zeitschlitzen des CMI-kodierten Binärsignals (201) zu synchronisieren; und
eine Einrichtung, um das rückgewonnene Taktsignal (204) auch dem D-Flipflop (2) zuzuführen, dadurch gekennzeichnet, daß die Taktrückgewinnungsschaltung ferner aufweist:
eine Abtasteinrichtung (2) zum Abtasten des rückgewonnenen Taktsignals (204) an einem Grenzpunkt jedes der Mehrzahl von Zeitschlitzen des CMI-kodierten Binärsignals (201), um dadurch ein abgetastetes Signal zu erzeugen, indem das D-Flipflop (2) verwendet wird, das einen Zeitsteuersignal-Eingangsanschluß (CK) aufweist, um ein invertiertes Signal des CMI-kodierten Binärsignals (201) zu empfangen, und einen Dateneingangsanschluß (D) aufweist, um das rückgewonnene Taktsignal (204) zu empfangen.
